# EUROPEAN PATENT SPECIFICATION

(11) **EP 1 938 360 B1**
(45) Date of publication and mention of the grant of the patent: **06.03.2013**
(21) Application number: 06826316.9
(22) Date of filing: 17.10.2006
(51) Int. Cl.: C23C 14/34, C23C 16/00, C25B 9/00, C25B 11/00, C25B 13/00, H01L 21/76, H01L 31/00, B05D 5/12

(54) **METHOD AND APPARATUS FOR CONVERTING PRECURSOR LAYERS INTO PHOTOVOLTAIC ABSORBERS**
VERFAHREN UND VORRICHTUNG ZUM UMSETZEN VON PRECURSOR-SCHICHTEN IN FOTOVOLTAISCHE ABSORBER
PROCEDE ET APPAREIL PERMETTANT DE CONVERTIR DES COUCHES DE PRECURSEURS EN ABSORBEURS PHOTOVOLTAIQUES

(30) Priority: 19.10.2005 US 728638 P; 14.03.2006 US 782373 P; 13.10.2006 US 549590
(43) Date of publication of application: 02.07.2008
(73) Proprietor: SoloPower, Inc., San Jose CA 95138 (US)
(72) Inventor: BASOL, Bulent, Manhattan Beach, CA 90266 (US)
(74) Representative: Freeman, Avi
(86) International application number: PCT/US2006/040968
(87) International publication number: WO 2007/047888

(56) References cited:
- EP-A1- 1 514 851
- WO-A2-2005/045091
- FR-A1- 2 843 129
- US-A- 5 578 503
- US-A- 6 048 442
- US-A- 6 092 669
- US-A1- 2003 033 983
- US-B1- 6 207 219

## Description

### FIELD OF THE INVENTION

The present invention relates to method and apparatus for preparing thin films of semiconductor films for radiation detector and photovoltaic applications.

### BACKGROUND

Solar cells are photovoltaic devices that convert sunlight directly into electrical power. The most common solar cell material is silicon, which is in the form of single or polycrystalline wafers. However, the cost of electricity generated using silicon-based solar cells is higher than the cost of electricity generated by the more traditional methods. Therefore, since early 1970's there has been an effort to reduce cost of solar cells for terrestrial use. One way of reducing the cost of solar cells is to develop low-cost thin film growth techniques that can deposit solar-cell-quality absorber materials on large area substrates and to fabricate these devices using high-throughput, low-cost methods.

Group IBIIIAVIA compound semiconductors comprising some of the Group IB (Cu, Ag, Au), Group IIIA (B, Al, Ga, In, Tl) and Group VIA (O, S, Se, Te, Po) materials or elements of the periodic table are excellent absorber materials for thin film solar cell structures. Especially, compounds of Cu, In, Ga, Se and S which are generally referred to as CIGS(S), or Cu(In,Ga)(S,Se)₂ or CuIn₁₋ₓGaₓ (S_{y}Se_{1-y})ₖ, where 0≤x≤1, 0≤y≤1 and k is approximately 2, have already been employed in solar cell structures that yielded conversion efficiencies approaching 20%. Absorbers containing Group IIIA element Al and/or Group VIA element Te also showed promise. Therefore, in summary, compounds containing: i) Cu from Group IB, ii) at least one of In, Ga, and Al from Group IIIA, and iii) at least one of S, Se, and Te from Group VIA, are of great interest for solar cell applications.

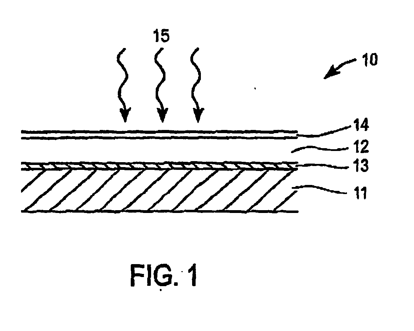

The structure of a conventional Group IBIIIAVIA compound photovoltaic cell such as a Cu(In,Ga,Al)(S,Se,Te)₂ thin film solar cell is shown in Figure 1. The device 10 is fabricated on a substrate 11, such as a sheet of glass, a sheet of metal, an insulating foil or web, or a conductive foil or web. The absorber film 12, which comprises a material in the family of Cu(In,Ga,Al)(S,Se,Te)₂ , is grown over a conductive layer 13, which is previously deposited on the substrate 11 and which acts as the electrical contact to the device. Various conductive layers comprising Mo, Ta, W, Ti, and stainless steel etc. have been used in the solar cell structure of Figure 1. If the substrate itself is a properly selected conductive material, it is possible not to use a conductive layer 13, since the substrate 11 may then be used as the ohmic contact to the device. After the absorber film 12 is grown, a transparent layer 14 such as a CdS, ZnO or CdS/ZnO stack is formed on the absorber film. Radiation 15 enters the device through the transparent layer 14. Metallic grids (not shown) may also be deposited over the transparent layer 14 to reduce the effective series resistance of the device. The preferred electrical type of the absorber film 12 is p-type, and the preferred electrical type of the transparent layer 14 is n-type. However, an n-type absorber and a p-type window layer can also be utilized. The preferred device structure of Figure 1 is called a "substrate-type" structure. A "superstrate-type" structure can also be constructed by depositing a transparent conductive layer on a transparent superstrate such as glass or transparent polymeric foil, and then depositing the Cu(In,Ga,Al)(S,Se,Te)₂ absorber film, and finally forming an ohmic contact to the device by a conductive layer. In this superstrate structure light enters the device from the transparent superstrate side. A variety of materials, deposited by a variety of methods, can be used to provide the various layers of the device shown in Figure 1.

In a thin film solar cell employing a Group IBIIIAVIA compound absorber, the cell efficiency is a strong function of the molar ratio of IB/IIIA. If there are more than one Group IIIA materials in the composition, the relative amounts or molar ratios of these IIIA elements also affect the properties. For a Cu(In,Ga)(S,Se)₂ absorber layer, for example, the efficiency of the device is a function of the molar ratio of Cu/(In+Ga). Furthermore, some of the important parameters of the cell, such as its open circuit voltage, short circuit current and fill factor vary with the molar ratio of the IIIA elements, i.e. the Ga/(Ga+In) molar ratio. In general, for good device performance Cu/(In+Ga) molar ratio is kept at around or below 1.0. As the Ga/(Ga+In) molar ratio increases, on the other hand, the optical bandgap of the absorber layer increases and therefore the open circuit voltage of the solar cell increases while the short circuit current typically may decrease. It is important for a thin film deposition process to have the capability of controlling both the molar ratio of IB/IIIA, and the molar ratios of the Group IIIA components in the composition. It should be noted that although the chemical formula is often written as Cu(In,Ga)(S,Se)₂, a more accurate formula for the compound is Cu(In,Ga)(S,Se)ₖ, where k is typically close to 2 but may not be exactly 2. For simplicity we will continue to use the value of k as 2. It should be further noted that the notation "Cu(X,Y)" in the chemical formula means all chemical compositions of X and Y from (X=0% and Y=100%) to (X=100% and Y=0%). For example, Cu(In,Ga) means all compositions from CuIn to CuGa. Similarly, Cu(In,Ga)(S,Se)₂ means the whole family of compounds with Ga/(Ga+In) molar ratio varying from 0 to 1, and Se/(Se+S) molar ratio varying from 0 to 1.

The first technique that yielded high-quality Cu(In,Ga)Se₂ films for solar cell fabrication was co-evaporation of Cu, In, Ga and Se onto a heated substrate in a vacuum chamber. However, low materials utilization, high cost of equipment, difficulties faced in large area deposition and relatively low throughput are some of the challenges faced in commercialization of the co-evaporation approach.

Another technique for growing Cu(In,Ga)(S,Se)₂ type compound thin films for solar cell applications is a two-stage process where metallic components of the Cu(In,Ga)(S,Se)₂ material are first deposited onto a substrate, and then reacted with S and/or Se in a high temperature annealing process. For example, for CuInSe₂ growth, thin layers of Cu and In are first deposited on a substrate and then this stacked precursor layer is reacted with Se at elevated temperature. If the reaction atmosphere also contains sulfur, then a CuIn(S,Se)₂ layer can be grown. Addition of Ga in the precursor layer, i.e. use of a Cu/In/Ga stacked film precursor, allows the growth of a Cu(In,Ga)(S,Se)₂ absorber.

Sputtering and evaporation techniques have been used in prior art approaches to deposit the layers containing the Group IB and Group IIIA components of the precursor stacks. In the case of CuInSe₂ growth, for example, Cu and In layers were sequentially sputter-deposited on a substrate and then the stacked film was heated in the presence of gas containing Se at elevated temperature for times typically longer than about 30 minutes, as described in U.S. 4,798,660. More recently U.S. Patent 6,048,442 disclosed a method comprising sputter-depositing a stacked precursor film comprising a Cu-Ga alloy layer and an In layer to form a Cu-Ga/In stack on a metallic back electrode layer and then reacting this precursor stack film with one of Se and S to form the absorber layer. U.S. Patent 6,092,669 described sputtering-based equipment for producing such absorber layers. Such techniques may yield good quality absorber layers and efficient solar cells, however, they suffer from the high cost of capital equipment, and relatively slow rate of production.

Two-stage process approach may also employ stacked layers comprising Group VIA materials. For example, a Cu(In,Ga)Se₂ film may be obtained by depositing In-Ga-selenide and Cu-selenide layers in a stacked manner and reacting them in presence of Se. Similarly, stacks comprising Group VIA materials and metallic components may also be used. In-Ga-selenide/Cu stack, for example, may be reacted in presence of Se to form Cu(In,Ga)Se₂.

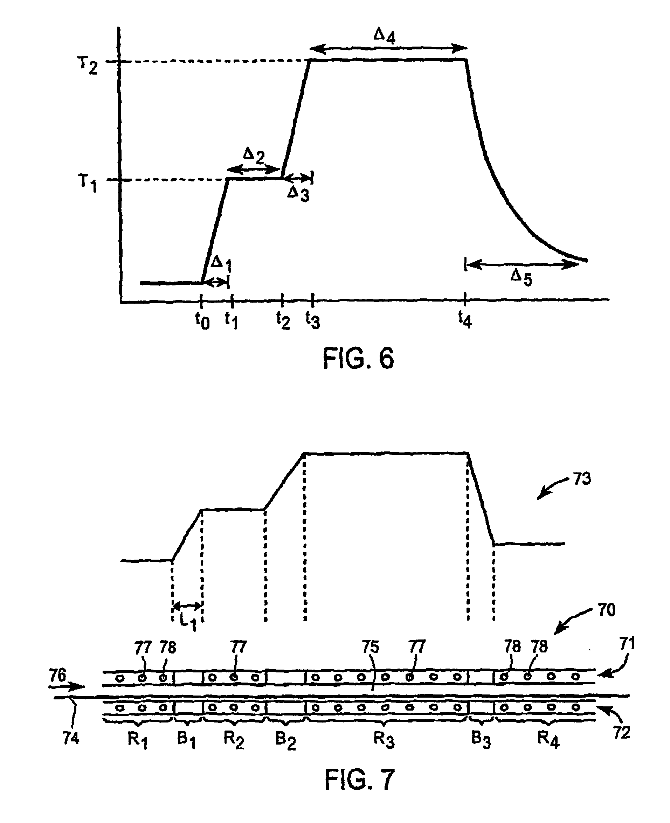

Reaction step in a two-stage process is typically carried out in batch furnaces where a large number of substrates are processed. One prior art method described in U.S. Patent 5,578,503 utilizes a rapid thermal annealing approach to react precursor layers in a "single-substrate" manner. In the "single-substrate" RTP approaches, the precursor film on a single base or substrate is loaded into a RTP reactor which is at room temperature, or at a temperature of < 100 C. The precursor film may comprise, for example, Cu, In, Ga and Se. Alternately, the precursor may comprise Cu, In and Ga and Se may be provided from a vapor phase in the reactor. The reactor is then sealed and evacuated to eliminate air/oxygen from the reaction environment. After evacuation, the reactor is backfilled with a gas and process is initiated. Reaction is typically carried out by varying or profiling the reactor temperature or the substrate temperature. A typical temperature profile used for CIGS film formation is shown in Figure 6. The heating of the reactor and the precursor film is initiated at time to and the temperature is raised to a first plateau T₁ within a time period Δ₁. The temperature T₁ may be in the range of 200-300 C. It is reported that ( V. Probst et al., MRS Symposium Proc. Vol. 426, 1996, p. 165) the rate of temperature increase during this time period Δ₁ is important, especially for precursor layers comprising a Se sub-layer on the surface of a metallic sub-layer comprising Cu, In and Ga. According to the above reference, this heating-up rate should be in the range of 10 C/sec to avoid excessive melting of Se which may deteriorate the morphology of the film being formed. After a period Δ₂ of initial reaction, temperature is again increased during the time interval Δ₃ between times t₂ and t₃ settling at a value T₂, which may be in the range of 450-550 C. After a reaction time period Δ₄, a cool-down period Δ₅ is initiated at time t₄ to bring the temperature of the reactor and the film, down to a level to allow safe unloading of the base or the substrate carrying the formed CIGS compound layer. This unload temperature is typically below 100 C, preferably below 60 C.

It should be appreciated that a "single-substrate" processing approach described above is time consuming since it involves evacuation, temperature cycling and then cooling down of the reactor for each loaded substrate. Also heating the reactor up to temperatures above 500 C and then cooling it down to room temperature or at least to a temperature of < 100 C, repeatedly, in a production environment may cause reliability issues. Since this is a "single substrate reaction" approach, very large area reactors are needed to increase the throughput. Furthermore, achieving very high heating rates (>10 C/sec) requires large amount of power at least during the heat-up periods of the temperature profile such as the one shown in Figure 6.

Irrespective of the specific approach used in a two-stage process, growing for example a Cu(In,Ga)(S,Se)₂ absorber film, individual thicknesses of the layers forming the precursor stacked structure need to be controlled so that the two molar ratios mentioned before, i.e. the Cu/(In+Ga) ratio and the Ga/(Ga+In) ratio, can be kept under control from run to run and on large area substrates. The molar ratios attained in the stacked structures are generally preserved in macro scale during the reaction step, provided that the reaction temperature is kept below about 600 °C. Therefore, the overall or average molar ratios in the compound film obtained after the reaction step is, generally speaking, about the same as the average molar ratios in the precursor stacked structures before the reaction step.

Selenization and/or sulfidation of precursor layers comprising metallic components may be carried out in various ways. One approach involves using gases such as H₂Se, H₂S or their mixtures to react, either simultaneously or consecutively, with the precursor comprising Cu, In and/or Ga. This way a Cu(In,Ga)(S,Se)₂ film is formed after annealing and reacting at elevated temperatures. It is possible to increase the reaction rate or reactivity by striking a plasma in the reactive gas during the process of compound formation. Se vapors or S vapors from elemental sources may also be used for selenization and sulfidation. Alternately, Se and/or S may be deposited over the precursor layer comprising Cu, In and/or Ga and the stacked structure can be annealed at elevated temperatures to initiate reaction between the metallic elements or components and the Group VIA material(s) to form the Cu(In,Ga)(S,Se)₂ compound.

Design of the reaction chamber to carry out selenization/sulfidation processes is critical for the quality of the resulting compound film, the efficiency of the solar cells, throughput, material utilization and cost of the process. Present invention resolves many of the non-uniformity, uncontrolled reaction rate issues and provide high-quality, dense, well-adhering Group IBIIIAVIA compound thin films with macro-scale as well as micro-scale compositional uniformities on selected substrates. Since the reactor volume is small, material cost is also reduced especially for the reaction gases. Small mass of the reactors increase processing speed and throughput.

### SUMMARY OF THE INVENTION

The present invention relates to method and apparatus for preparing thin films of semiconductor films for radiation detector and photovoltaic applications.

In one aspect, the present invention includes a series of chambers between the inlet and the outlet, with each chamber having a gap that allows a substrate to pass therethrough, and which is temperature controlled, thereby allowing each chamber to maintain a different temperature, and the substrate to be annealed based upon a predetermined temperature profile by efficiently moving through the series of chambers at a predetermined speed profile.

In another aspect, each of the chambers opens and closes, and creates a seal when in the closed position during which time annealing takes place within the gap of the chamber.

In a further aspect, the present invention provides a method of forming a Group IBIIIAVIA compound layer on a surface of a flexible roll. The method includes depositing a precursor layer comprising at least one Group IB material and at least one Group IIIA material on the surface of the flexible roll, providing at least one Group VIA material to an exposed surface of the precursor layer; and annealing, after or during the step of providing, the flexible roll using a series of process chambers, the step of annealing including feeding the flexible roll having the deposited precursor layer thereon from an inlet, through the series of process chambers to an outlet, each process chamber having a gap therein set to a predetermined temperature, thereby applying the predetermined temperature to a section of the flexible roll within the gap associated therewith.

### BRIEF DESCRIPTION OF THE DRAWINGS

These and other aspects and features of the present invention will become apparent to those of ordinary skill in the art upon review of the following description of specific embodiments of the invention in conjunction with the accompanying figures, wherein:

FIG. 1 is a cross-sectional view of a solar cell employing a Group IBIIIAVIA absorber layer.

FIG. 2 shows an apparatus to form a Group IBIIIAVIA layer.

FIG. 3A shows a cross-sectional sketch of a process chamber with upper and lower bodies moved away from each other.

FIG 3B shows a cross-sectional sketch of a process chamber with upper and lower bodies moved towards each other for sealing one portion of the substrate for processing in the chamber.

FIG. 3C shows another process chamber in sealed position.

FIG 3D shows another process chamber.

FIG. 4 shows a processing unit comprising multiple sections for multiple processes.

FIG. 5 shows a processing unit enclosed by a secondary enclosure.

FIG. 6 shows a temperature profile used in a RTP approach.

FIG. 7 shows a small gap reactor and its temperature profile.

FIG. 8 shows a section of a variable gap reactor.

### DETAILED DESCRIPTION

Reaction of precursors, comprising Group IB material(s), Group IIIA material(s) and optionally Group VIA material(s) or components, with Group VIA material(s) may be achieved in various ways. These techniques involve heating the precursor layer to a temperature range of 350-600 °C in the presence of at least one of Se, S, and Te provided by sources such as solid Se, solid S, solid Te, H₂Se gas, H₂S gas, H₂Te gas, Se vapors, S vapors, Te vapors etc. for periods ranging from 1 minute to 1 hour. The Se, S, Te vapors may be generated by heating solid sources. Hydride gases such as H₂Se and H₂S may be bottled gases. Such hydride gases and short-lifetime gases such as H₂Te may also be generated in-situ, for example by electrolysis in aqueous acidic solutions of cathodes comprising S, Se and/or Te, and then provided to the reactors. Electrochemical methods to generate these hydride gases are suited for in-situ generation. Precursor layers may be exposed to more than one Group VIA materials either simultaneously or sequentially. For example, a precursor layer comprising Cu, In, Ga, and Se may be annealed in presence of S to form Cu(In,Ga)(S,Se)₂. The precursor layer in this case may be a stacked layer comprising a metallic layer containing Cu, Ga and In and a Se layer that is deposited over the metallic layer. Alternately, Se nano-particles may be dispersed throughout the metallic layer containing Cu, In and Ga. It is also possible that the precursor layer comprises Cu, In, Ga and S and during reaction this layer is annealed in presence of Se to form a Cu(In,Ga)(S,Se)₂. Some of the preferred approaches of forming a Cu(In,Ga)(S,Se)₂ compound layer may be summarized as follows: i) depositing a layer of Se on a metallic precursor comprising Cu, In and Ga forming a structure and reacting the structure in gaseous S source at elevated temperature, ii) depositing a mixed layer of S and Se or a layer of S and a layer of Se on a metallic precursor comprising Cu, In and Ga forming a structure, and reacting the structure at elevated temperature in either a gaseous atmosphere free from S or Se, or in a gaseous atmosphere comprising at least one of S and Se, iii) depositing a layer of S on a metallic precursor comprising Cu, In and Ga forming a structure and reacting the structure in gaseous Se source at elevated temperature, iv) depositing a layer of Se on a metallic precursor comprising Cu, In and Ga forming a structure, and reacting the structure at elevated temperature to form a Cu(In,Ga)Se₂ layer and then reacting the Cu(In,Ga)Se₂ layer with a gaseous source of S, liquid source of S or a solid source of S such as a layer of S, v) depositing a layer of S on a metallic precursor comprising Cu, In and Ga forming a structure, and reacting the structure at elevated temperature to form a Cu(In,Ga)S₂ layer, and then reacting the Cu(In,Ga)S₂ layer with a gaseous source of Se, liquid source of Se or a solid source of Se such as a layer of Se.

It should be noted that Group VIA materials are corrosive. Therefore, materials for all parts of the reactors or chambers that are exposed to Group VIA materials or material vapors at elevated temperatures should be properly selected. These parts should be made of or should be coated by substantially inert materials such as ceramics, e.g. alumina, tantalum oxide, titania, zirconia etc., glass, quartz, stainless steel, graphite, refractory metals such as Ta, refractory metal nitrides and/or carbides such as Ta-nitride and/or carbide, Ti-nitride and/ or carbide, W-nitride and/or carbide, other nitrides and/or carbides such as Si-nitride and/or carbide, etc.

In another embodiment, a layer or multi layers of Group VIA materials are deposited on the precursor layer or stacks or mixtures of Group IB, Group IIIA and Group VIA materials are formed, and the stacked layers are then heated up in a furnace, in a rapid thermal annealing furnace, or laser annealing system and like to cause intermixing and reaction between the precursor layer and the Group VIA materials. Group VIA material layers may be obtained by evaporation, sputtering, or electroplating. Alternately inks comprising Group VIA nano particles may be prepared and these inks may be deposited to form a Group VIA material layer comprising Group VIA nano particles. Other liquids or solutions such as organo-metalic solutions comprising at least one Group VIA material may also be used. Dipping into melt or ink, spraying melt or ink, doctor-blading or ink writing techniques may be employed to deposit such layers.

As described above, it is also possible to use the above mentioned selenization and/or sulfidation techniques together, e.g. have a solid film of group VIA material on the precursor layer and carry out reaction in Group VIA material vapor or gases. Reaction may be carried out at elevated temperatures for times ranging from 1 minute to 60 minutes depending upon the temperature, the film thickness and exact composition and morphology of the precursor layer. As a result of reaction, the Group IBIIIAVIA compound is formed from the precursor.

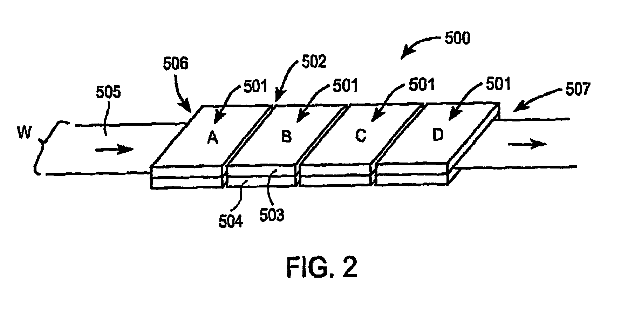

One apparatus 500 to carry out the reaction step of a precursor layer to form a Group IBEIIAVIA compound film is shown in Figure 2. It should be noted that the precursor layer to be reacted in this reactor may comprise at least one Group IB material and at least one Group IIIA material. For example the precursor layer may be a stack of Cu/In/Ga, Cu-Ga/In, Cu-In/Ga, Cu/In-Ga, Cu-Ga/Cu-In, Cu-Ga/Cu-In/Ga, Cu/Cu-In/Ga, or Cu-Ga/In/In-Ga etc., where the order of various material layers within the stack may be changed. Here Cu-Ga, Cu-In, In-Ga mean alloys or mixtures of Cu and Ga, alloys or mixtures of Cu and In, and alloys or mixtures of In and Ga, respectively. Alternatively, the precursor layer may also include at least one Group VIA material. There are many examples of such precursor layers. Some of these are Cu/In/Ga/Group VIA material stack, Cu-Group VIA material/In/Ga stack, In-Group VIA material/Cu-Group VIA material stack, or Ga-Group VIA material/Cu/In, where Cu-Group VIA material includes alloys, mixtures or compounds of Cu and a Group VIA material (such as Cu-selenides, Cu sulfides, etc.), In-Group VIA material includes alloys, mixtures or compounds of In and a Group VIA material (such as In-selenides, In sulfides, etc.), and Ga-Group VIA material includes alloys, mixtures or compounds of Ga and a Group VIA material (such as Ga-selenides, Ga sulfides, etc.). These precursors are deposited on a base comprising a substrate 11, which may additionally comprise a conductive layer 13 as shown in Figure 1. Other types of precursors that may be processed using the method and apparatus of the invention includes Group IBIIIAVIA material layers that may be formed on a base using low temperature approaches such as compound electroplating, electroless plating, sputtering from compound targets, ink deposition using Group IBIIIAVIA nano-particle based inks etc. These material layers are then annealed in the apparatus or reactors at temperatures in the 200-600 °C range to improve their crystalline quality, composition and density.

Annealing and/or reaction steps may be carried out in the reactors of the present invention at substantially the atmospheric pressure, at a pressure lower than the atmospheric pressure or at a pressure higher than the atmospheric pressure. Lower pressures in reactors may be achieved through use of vacuum pumps. For low pressure and high pressure reactors sealing need to be provided not to let outside air to get into the reactor or the reactive gases to get out. During reaction of the precursor layers with Group VIA materials, use of high reaction pressure may be advantageous to increase reactivity of the Group VIA materials and to increase their boiling temperatures. Higher pressure may be obtained in the reactors through overpressure of the Group VIA material species or through increased partial pressure of other gasses such as nitrogen, hydrogen and helium that may be used in the reactor. After the reaction is complete it may be beneficial to heat the formed compound layers in low pressure reactors. This would get the excess Group VIA materials off the formed compound layers and improve their electrical, mechanical and compositional properties.

The apparatus 500 comprises a series of chambers 501 that are placed next to each other in a linear fashion. The chambers 501 may be separated from each other by a small gap 502, or alternately all chambers 501 may structurally be connected to each other, however they may be internally separated through use of seals or spacers as will be discussed later. The chambers 501 comprise an upper body 503 and a lower body 504 that are separable from each other by a predetermined distance. A base or substrate 505 has a width of W and enters the apparatus 503 at inlet 506 and exits the apparatus 503 at an outlet 507. The substrate 505 may be a continuous web or sheet of a metal or an insulator comprising a precursor layer to be reacted to form the compound film. Alternately there may be a carrier on which pre-cut substrates comprising the precursor layers may be placed. The carrier may then carry these pre-cut substrates through various process chambers. There are mechanisms (not shown) that move the substrate laterally through the apparatus 500 and move the upper body 503 and/or the lower body 504 of the process chambers to achieve relative motion between the upper and lower bodies. Preferably, the substrate may be moved by an increment from left to right after the upper body 503 is moved away from the lower body 504 and then subsequently the upper body 503 and lower body 504 are brought closer to sandwich the substrate (or carrier in case a carrier is used) between them and the processing is carried out for a predetermined period of time.

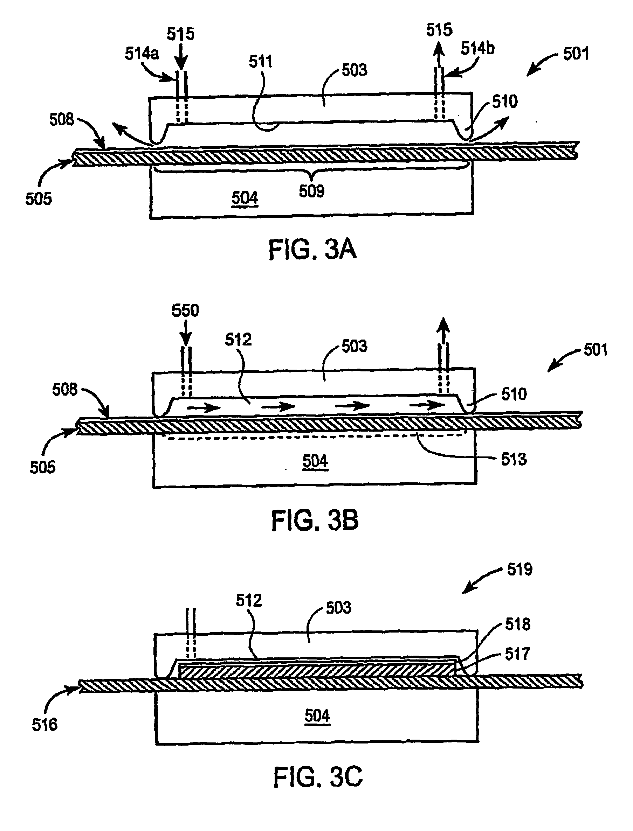

Figure 3A shows in more detail a cross-sectional view of a chamber 501. In this figure the upper body 503 is moved away from the lower body 504, and a section 509 of the substrate 505 is placed between the upper body 503 and the lower body 504.The substrate 505 comprises a precursor layer 508 that is to be processed. The upper body 503 has a shallow cavity 511 and the lower body 504 is substantially flat. In a preferred embodiment the length of the section 509 may be (15,2-152 cm (0.5-5 ft), whereas the depth of the cavity 511 may be in the range of 0.5-10 mm, more preferably 1-5 mm. The width of the substrate may be in the range of 15,2-305 cm (0.5-10 ft), preferably 30,5-152 cm (1-5 ft). Once the section 509 of the substrate 505 is in place, either the upper body 503 or the lower body 504 or both are moved towards each other until spacer 510 makes contact with or comes to close proximity (within about 1 mm) of the precursor layer 508 as shown in Figure 3B. This way a process gap 512 is formed above the precursor layer 508 and the upper body 503. It should be noted that the spacer 510 may seal the process gap if high temperature sealing materials are used as spacers. Alternately, the spacer may be a leaky seal and a positive gas pressure may be kept within the process gap 512 so that undesirable gases do not leak from outside into the process gap 512 during processing.

As can be seen from Figure 3B the seal or leaky seal is made against or onto the precursor layer or the substrate. An alternative embodiment is shown in Figure 3C where the seal or leaky seal is made against or onto a carrier 516 which carries a pre-cut substrate 517 comprising a precursor layer 518 into the chamber 519. In this case some of the details of the chamber 519, such as gas inlets, outlets etc. are not shown to simplify the figure. We will now continue describing the invention using the chamber design shown in Figures 3A and 3B. It should be understood that variants of this design and the design shown in Figure 3C may also be used in a similar manner.

As the section 509 of the substrate 505 is being moved into the chamber 501 a gas 515 may be flown through at least one of the gas tubes 514a and 514b and expelled through the openings between the precursor layer 508 and the spacer 510 as shown by the arrows in Figure 3A. This way atmospheric gases and especially oxygen within the narrow process gap 512 above the precursor layer surface may be replaced with the gas flown through the gas tubes in a very short period of time such as within 1-10 seconds. This is important for throughput of the process as well as the quality of the compound film formed because when the section 509 of the substrate is at position shown in Figure 3A, the lower body 504 may already be heated and may start to heat the precursor layer 508. To avoid reaction of the precursor layer 508 with the undesired atmosphere, there is a need to replace the atmosphere very quickly with a controlled atmosphere that may be provided by the gas flown through the gas tubes into the process gap 512. In the example of Figure 3A both gas tubes 514a and 514b are used as gas inlets. The gas 515 may be an inert gas such as nitrogen, argon or helium or a reducing gas such as a mixture of hydrogen (e.g. 2-5% mixture) with any inert gas. This way the atmosphere left over from the previous process step in the cavity is quickly replaced with a fresh inert or reducing atmosphere by the time the spacer 510 comes in close proximity of the precursor layer 508 forming the process gap 512. Once processing starts additional gases such as reactive gases may then be flown into the process gap 512 and some of the gas inlets 515 may be used as gas outlets such as shown in Figure 3B. Alternately there may be different sets of dedicated gas inlets and gas outlets. The small gap reactor shown in Figure 3B is well suited for plasma generation within the process gap. Activity enhancing methods such as plasma generation very close to the processed film surface accelerates reaction and reduces processing time. For example, presence of plasma within the process gap enhances reaction rate of Group VIA material with the precursor layer and accelerates formation of Group IBIIIAVIA compound layer. Alternately, the gas entering the process gap may be passed through a plasma, just before it enters the process gap. For example, a gas comprising Group VIA material may be passed through a plasma chamber outside and then flown into the process gap with the activated Group VIA material species. This also increases the process throughput.

The base or substrate may be engaged onto the lower body surface by various means including keeping the substrate under tension (in case of flexible web substrates), magnetic coupling, electrostatic chuck etc. Close mechanical contact between the lower body surface and the substrate is important, especially in cases where the temperature of the substrate is controlled by the temperature of the lower body as we will discuss later.

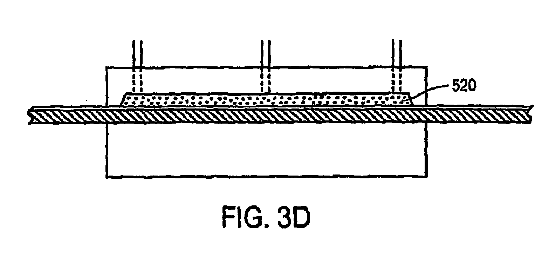

Although a preferred geometry of the chamber is shown in Figures 3A, 3B and 3C, several changes may be made to the design. For example, instead of being lateral, the chambers may be placed vertically and the substrate may travel through them in a vertical manner. Similarly the chamber may be rotated 180 degrees and process may be applied to the precursor layer while the precursor layer faces down in order to avoid particles dropping on its surface during reaction. There may be an additional cavity or a lower cavity 518 shown as dotted lines in Figure 3B in the lower body 504 and the substrate may be suspended between the cavity 512 and the lower cavity 513. There may be gas lines bringing in and carrying out gases to and from the lower cavity 513. It is also possible to eliminate the cavity 511 and touch the precursor layer surface during the process by the upper body 503 to achieve a near-zero gap between the exposed surface of the precursor layer and the upper body 503. At least part of the upper body 503 facing the precursor layer 508 may be made porous to allow gasses or vapors to be fed towards the precursor layer surface in a diffused and well distributed manner. This is shown in Figure 3D wherein the chamber is shown with a porous section 520 which is in physical contact or in close proximity (within about 1 mm) of the precursor layer. There may additionally be heating means (not shown) such as heater coils within the porous section to control its temperature.

In any of the reactors as described above, during reaction, a mechanism can be included that allows for relative motion and physical contact between the precursor layer and a soft high-temperature material, such as quartz wool. The relative motion between the soft high-temperature material and the precursor layer may distribute the reactant more uniformly to yield better uniformity in reaction.

In one preferred embodiment (see Figure 3B) the lower body 504 of the chamber 519 may be held at the process temperature such as at a temperature of 200-600 °C, and as soon as the seal or leaky seal is made by the spacer 510, process gas 550 may start flowing into the process gap 512 and annealing and/or reaction starts within the precursor layer. As already described, a gas 515 (see Figure 3A) is previously flown to replace any unwanted gases or atmosphere (such as air) within the process gap 512 before the process gas 550 starts to come into the process gap 512. It is possible that the gas 515 and the process gas 550 are the same gas, for example nitrogen. This depends on the nature of the precursor layer 508. In general, if the precursor layer 508 comprises Group VIA material(s) such as Se, then the process gas 550 may be an inert gas such as nitrogen, argon or helium, and during reaction the Group VIA material within the precursor layer reacts with the Group IB and Group IIIA materials forming the Group IBIIIAVIA compound layer. Otherwise, the process gas may comprise species comprising the Group VIA material, to provide to the reaction or to keep certain overpressure of the volatile Group VIA material over the surface of the reacting precursor layer. Therefore, the process gas 550 may comprise Se vapor, S vapor, H₂Se, H₂S, etc. Furthermore it is possible to change the gas during the process. For example, at the beginning of the process the process gas 550 may comprise Se. Later in the process, after the precursor reacts with Se and forms Cu(In,Ga)Se₂ the gas may be changed to an inert gas and annealing may be performed for grain growth and/or for making the Ga concentration profile within the film more uniform. Alternately after the formation of the Cu(In,Ga)Se₂ layer, the process gas may change into one comprising S to convert the film into a Cu(In,Ga)(S,Se)₂ layer. These process steps may be carried out in a single chamber such as the ones shown in Figures 3A, 3B, 3C and 3D, or each step may be carried out in a dedicated chamber in a system with multiple chambers in a line such as the system shown in Figure 2, or in a cluster system employing a central robot that carries substrates to and from multiple process chambers. In addition to the lower body 504, the upper body 503 may also be heated to assure temperature uniformity over the section of the substrate within the chamber and also to avoid excessive precipitation of the Group VIA volatile species on the upper body walls. There may be holes in the lower body 504 (not shown) of Figures 3A, 3B, 3C and 3D that can direct a gas stream to the bottom side of the substrate 505. When the reaction step is over, for example, a gas such as nitrogen may be directed to the back side of the substrate as the upper body 503 is moved up. This way the thermal coupling is broken between the substrate and the lower body 504 by floating the substrate on a thin blanket of gas. By controlling the composition of the gas (selecting high thermal conductivity or low thermal conductivity gases or their mixtures) the cooling rate of the substrate may also be controlled.

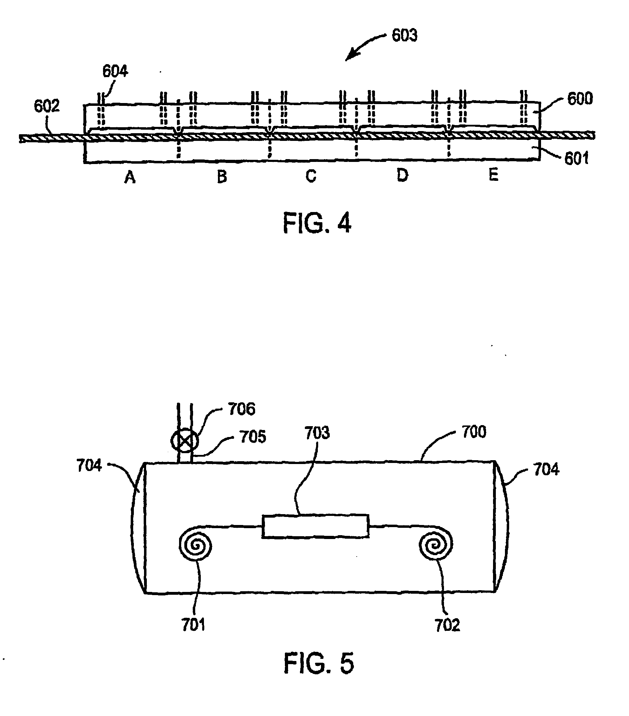

Above embodiment described a case where the process temperature or reaction temperature was mainly controlled by the temperature of the lower body 504 with optional heating means within the upper body 503. In this case, if a varying process temperature profile is needed (for example temperature stepping from room temperature to 150-250 °C range and staying there 0.5-15 minutes and then increasing to 400-600 °C and staying there for an additional 0.5-5 minutes) the temperature of the lower body 504 may be changed rapidly to achieve the desired temperature-time profile for the process. Alternatively, in a multi chamber system such as the one in Figure 2, one chamber, such as chamber A may have the lower body temperature set at one temperature, such as to the 150-250 °C range, and the next chamber B may have the lower body temperature set at another temperature, such as at a range of 400-600 °C. A specific section of the substrate is then first processed in chamber A for 0.5-15 minutes and then moved to chamber B to get processed for an additional 0.5-15 minutes at the higher temperature. This way different sections of the substrate, which may either be a single piece or a pre-cut piece (see Figure 3C), get processed in different chambers under different conditions. This is a "stepped, in-line" process that offers flexibility of changing temperatures and reaction atmospheres rapidly in a high throughput process. During the motion of the substrate sections between chambers the upper body and lower body of the chambers move away from each other forming a narrow slit allowing the substrate or the carrier to move. During this time inert gases may be flown into the chambers and flood the gaps 502 to protect the hot portions of the precursor layer or the partially reacted layer from reacting with the environment outside the chambers. If the gaps are eliminated and/or a secondary enclosure (not shown) is placed around the apparatus 500, then the atmosphere outside the chambers 501 may also be controlled. For example, the secondary enclosure may continuously be flushed with nitrogen assuring nonreactive environment. An example of a secondary enclosure 700 is shown in Figure 5 as applied to a process unit processing flexible foil substrates. In this case a supply spool 701 and a receiving spool 702 for the flexible substrate is placed in the secondary enclosure 700 along with a multi chamber system 703, which may be a processing unit or apparatus such as the one depicted in Figure 2. Secondary enclosure 700 may have at least one door 704 for access, at least one gas line 705 for flowing gasses in and out of the enclosure 700 and/or pulling vacuum in the enclosure 700. Appropriate number of valves 706 may be used to shut off gas flows or vacuum when necessary. It should be appreciated that a two level reactor design such as the one shown in Figure 5 allows flexibility of controlling the atmosphere around the reactors which are within the multi-chamber system 703. For the case of processing rigid substrates such as glass sheets in a step-wise continuous manner a load port and an unload port or load-locks may be placed on the left and right side of the enclosure 700. These ports or load-locks may seal the inside volume of the enclosure 700 from outside atmosphere during substrate transfer into the enclosure 700.

In another embodiment the process temperature is mainly determined by the upper body 503. In this case the lower body 504 may be at room temperature or at a predetermined constant temperature that may be less than 150 °C. A gas with low thermal conductivity, such as nitrogen (0.026 W/m), may be flown until the seal or leaky seal is established (see Figure 3A). During this time the temperature of the precursor layer is controlled by the lower body 504. Once the seal is established a high thermal conductivity gas such as He (0.156 W/m) and/or H₂ (0.18 W/m) may be introduced in the process gap 512 along with other desired ingredients such as Group VIA material vapors. Due to thermal coupling of the precursor layer to the upper body 503 through the thermally conductive gas, the temperature of the precursor layer may be raised towards the temperature of the upper body 503 and the process of reaction may be initiated. In this example the temperature of the upper body may be controlled in the range of 200-600 °C.

Alternately, in a design with two cavities (see Figure 3B), both the temperature of the lower body 504 and the temperature of the upper body 503 may play a role in determining the temperature of the precursor layer or the process temperature. In this case if, for example, a high thermal conductivity gas is flown into the upper cavity 511 and a low thermal conductivity gas is flown into the lower cavity, the temperature of the substrate or the precursor layer will be mostly determined by the temperature of the upper body 503. If, on the other hand, a high thermal conductivity gas is flown into the lower cavity 513 and a low thermal conductivity gas is flown into the upper cavity 511, the temperature of the substrate or the precursor layer will be mostly determined by the temperature of the lower body 504. By changing composition of gasses in the upper and lower cavities therefore, different temperature-time profiles may be achieved using this design.

An example will now be given to describe one embodiment of the present invention.

Example: A Mo coated stainless steel or aluminum foil may be used as the base. A metallic precursor comprising Cu, In, and Ga may be deposited on the base. Multi-chamber process unit 603 shown in Figure 4 may be used for the formation of a Cu(In,Ga)(S,Se)₂ layer on the base. The base comprising the metallic precursor layer is depicted in Figure 4 as substrate 602. The process unit 603 has chambers or sections indicated by dotted lines and labeled as A, B, C, D and E. The process unit has a single top body 600 and a single bottom body 601. Within the top body 600 and the bottom body 601 there are independent heating means to independently change and control temperatures of the individual sections A, B, C, D and E. There are also independent gas lines 604 that may act as gas inlets or outlets for each section.

In this example, section A is used for Se deposition on the metallic precursor. Section B is used for initial reaction at a temperature of 150-250 °C. Section C is used for complete reaction at 400-600 °C. Section D is used for S inclusion and section E is used for annealing.

During processing, a first portion of the substrate 602 is placed in section A of the process unit 603. After sealing, gas line in section A brings in Se vapor which condenses and forms a Se layer on the metallic precursor in the first portion of the substrate 602. Next the top body 600 and the bottom body 601 are slightly separated from each other and the substrate 602 is moved bringing the first portion of the substrate into section B of the process unit 603 while bringing a second portion of the substrate into the section A of the process unit 603. The top body 600 and/or the bottom body 601 are then moved towards each other to establish seals or leaky seals for all the sections. This time, while the initial reaction step is carried out on the first portion of the substrate, a selenium deposition step is carried out on the second portion. The initial reaction step may comprise partially reacting the metallic precursor layer with the deposited Se layer at a temperature, preferably below the melting temperature of Se as to avoid flow patterns and non-uniformities on the forming compound layer. After the initial reaction step is completed, the substrate is moved again as described before, bringing the first portion into section C, the second portion into section B and a third portion into section A. In section C a high temperature reaction is carried out at temperatures above 400 °C for a period that may range from 0.5 minutes to 15 minutes. During this step, additional Se containing gases may be introduced into the process gap in section C to make sure there is excess Se overpressure in the reaction environment. It should be noted that as the high temperature reaction is carried out on the first portion of the substrate in section C of the process unit 603, Se deposition is carried out in section A on the third portion of the substrate and the initial reaction step is carried out on the second portion in section B.

In the next step of the overall process the first portion of the substrate is exposed to S containing environment in section D of the process unit 603 at elevated temperatures of 400-600 °C for a time period in the range of 0.5-15 minutes. During this process step some of the Se in the Cu(In,Ga)Se₂ layer formed in section C is replaced by S forming a Cu(In,Ga)(S,Se)₂ compound film. The last section E of the process unit 603 may be used for additional annealing for grain growth and/or compositional uniformity improvement or for the purpose of stepwise cooling down the substrate.

The example above utilizes a series configuration for the process unit where the processing time is determined by the longest process step. It is of course within the scope of this invention to form a process unit running different process steps in parallel, through for example the use of a cluster tool.

The tool or reactor designs of this invention may also be used for continuous, in-line processing of substrates which may be in the form of a web or in the form of large sheets such as glass sheets which may be fed into the reactor in a continuous manner. We will describe these aspects using roll-to-roll web processing in the examples below.

The disadvantages of the prior-art "single-substrate" RTP approaches, where the temperature of the RTP chamber is raised and lowered continually during processing, were previously discussed. The in-line RTP reactor designs of the present invention are flexible, lower-cost and higher throughput, and they specifically are suited for CIGS(S) type of compound film formation. Figure 7 shows a cross sectional schematic of a small-gap, in-line, RTP reactor 70 comprising multiple sections or regions. There are four temperature profile regions (R₁, R₂, R₃, R₄) and three buffer regions (B₁, B₂, B₃) within the top body 71 and bottom body 72 of the reactor 70. A substrate 74 or a base is fed through the gap 75 of the reactor 70 in the direction of arrow 76. The substrate 74 may be a foil with a precursor layer (not shown) on it, precursor comprising Cu, In, Ga and optionally at least one of Se and S. The goal is to convert the precursor on a given section of the substrate 74 into a CIGS(S) compound as the given section of the substrate 74 exits the reactor on the right hand side.

The temperature profile regions have heating means 77 and cooling means 78 distributed in the top body 71 and the bottom body 72. The heating means 77 may be heater elements such as heater rods. Cooling means 78 may be cooling coils circulating a cooling gas or cooling liquid. Although the buffer regions may also have heating and cooling means, preferably they do not contain such means. Preferably the buffer regions are made of low thermal conductivity materials such as ceramics so that they can sustain a temperature gradient across them as shown by the reactor profile 73. The heating means 77 and cooling means are distributed to obtain the reactor profile 73. For example, the last region R4 and the lower temperature ends of the buffer regions B₁ and B₂ may have cooling means 78 while heating means 77 may be distributed everywhere else.

The reactor profile 73 is an exemplary temperature vs. distance profile of the reactor 70. It should be noted that the reactor profile 73 is different from the temperature vs. time plot of a "single-substrate" reactor shown in Figure 6. The temperature vs. time plot of Figure 6 shows the temperature profile experienced by a substrate placed in the "single-substrate" reactor. The temperature vs. time profile experienced by any section of the substrate 74 in the reactor 70 of Figure 7 can be changed and controlled by changing and controlling the speed at which the substrate 74 is moved from left to right through the gap 75. For example, if the distance L₁ is 5 cm and the substrate 74 is moved at a velocity of 1 cm/second, then a point on the substrate 74 will pass through the buffer region B₁ in 5 seconds. If, for example, the temperatures at the left and right ends of the buffer region B₁ are 100 C and 300 C, this means that the point on the substrate 74 will experience a temperature profile that goes from 100 C to 300 C in 5 seconds. This corresponds to a heating rate of 40 C/seconds. As can be appreciated, reaching such heating rates in a "single-substrate" reactor is very difficult and requires very high power density. For the in-line RTP reactor of Figure 7, however, the reactor profile 73 is established once and then it stays unchanged. By changing the velocity of the substrate the temperature profile experienced by the substrate may be changed at will. Lack of heating and cooling the reactor continually in a cyclic manner increases reliability and reduces power consumption.

As described previously, more sections may be added to the reactor design of Figure 7. Each section may perform a different function such as reacting Cu, In, Ga with Se, reacting the already formed Cu(In,Ga)Se₂ with S, annealing the already formed compound layer in an inert atmosphere etc. These sections may be separated from each other by soft barriers that may touch the surface of the already reacted precursor layer. Such barriers may be made of high temperature materials such as high temperature fibers or wools. This way cross talk between various sections of the reactor is minimized, especially if different gases are introduced in different sections.

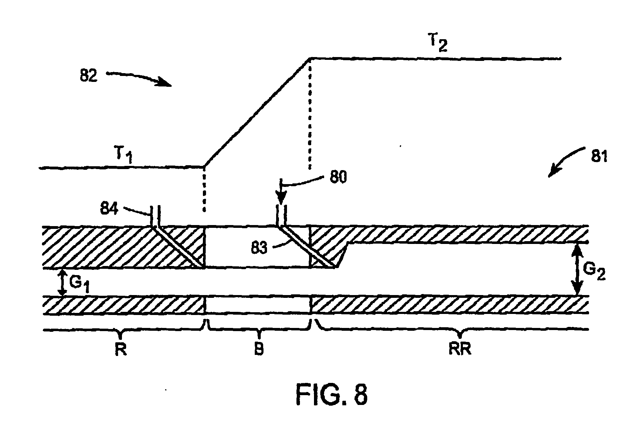

It is also possible to change the gap of the reactor between or within each temperature profile region or buffer region. Figure 8 shows an exemplary section 81 of an in line reactor, wherein two temperature profile regions (R and RR) and one buffer region (B) is shown. The temperature vs. distance curve of the section 81 is also shown as plot 82 in the same figure. The section 81 in Figure 8 has two different gaps. A gap of G₁ is provided within the low temperature region R which is kept at a temperature of T₁, and at the buffer region B. The gap changes from G₁ to G₂ within the high temperature region RR, which is kept at a temperature of T₂. The significance of this gap change will now be discussed in relation with reacting a Cu/In/Ga/Se precursor stack on a foil substrate such as a Mo coated stainless steel web.

Let us assume that the temperature T₁ is about 100 C and the temperature T₂ is about 300 C. As the web (not shown) moves from left to right within the gap of the reactor section 81 a portion of the precursor stack on the web gets heated from 100 C to 300 C by a rate that is determined by the speed of the web as discussed before. When the temperature of the portion increases, Cu, In, Ga and Se start reacting to form compounds. At the same time any excess Se starts to vaporize since its vapor pressure is a strong function of temperature. The selenium vapor formed in the gap would normally travel towards the cool end of the reactor, i.e. to the region R, and one there, would solidify since the temperature of region R is 100 C, which is lower than 217 C, the melting point of Se. Similarly a liquid phase may also form within the gap in the buffer region B where temperature is at or higher than 217 C. As a result as more and more portions of the web enter the reactor and get processed, more and more Se accumulation may be observed in the colder sections of the reactor and eventually the gap may be filled with Se. Therefore, measures need to be taken to stop Se vapors from diffusing to the cold sections or regions of the reactor. In the variable gap design of Figure 8, gas inlets 83 are placed near the edge of the high temperature region RR to direct a gas 80 from the smaller gap section towards the larger gap section of the reactor. Such gas flow pushes the Se vapors away from the colder sections towards the hotter sections. It should be noted that the gas may be an inert gas such as N₂ and it may be introduced within the lower gap section also as indicated by inlet 84. Once the gas enters the gap it finds a lower resistance path flowing towards the larger gap region RR compared to the smaller gap region R. Therefore, a gas flow is established to discourage Se vapors entering the colder region R.

Solar cells may be fabricated on the compound layers of the present invention using materials and methods well known in the field. For example a thin (<0.1 microns) CdS layer may be deposited on the surface of the compound layer using the chemical dip method. A transparent window of ZnO may be deposited over the CdS layer using MOCVD or sputtering techniques. A metallic finger pattern is optionally deposited over the ZnO to complete the solar cell.

## Claims

1. An in-line reactor to process a substrate according to a predetermined temperature profile,
the reactor comprising;
a substrate inlet;
a substrate outlet;
a series of chambers between the inlet and the outlet, each chamber including:
an upper body,
a lower body,
a gap formed between the upper body and the lower body, wherein the gap includes a width, a height and a length, and wherein a ratio of a narrowest width to a narrowest height for each chamber is at least 15, and wherein the gap of each of the series of chambers is aligned with the gap of the other chambers in the series, and
a temperature controller that regulates the temperature within the gap based upon the predetermined temperature profile so that there is a different temperature within the gap of at least some of the chambers;
a mechanism to move the substrate from the inlet to the outlet through each gap of the series of chambers; and
at least one gas inlet configured to deliver a gas into the gap of a corresponding at least one of the chambers.

2. The reactor according to claim 1, wherein adjacent chambers are separated by a buffer region.

3. The reactor according to claim 2, wherein the gap height within at least one chamber varies across its width.

4. The reactor according to claim 3, wherein the gap height within at least one chamber varies across its length.

5. The reactor according to claim 2, wherein the gap height within at least one chamber varies across its length.

6. The reactor according to claim 1, wherein the gap height within at least some of the chambers is different.

7. The reactor according to claim 1, wherein the gap height within each chamber is substantially the same.

8. The reactor according to claim 1, wherein the temperature controller controls a heating element and a cooling element.

9. The reactor according to claim 1 wherein the mechanism includes a supply spool and a receiving spool that are used to supply and receive, respectively, a flexible foil substrate.

10. The reactor according to claim 2, further comprising an enclosure that contains the series of chambers and the mechanism.

11. The reactor according to claim 1 further including at least one of Se-containing gas and S-containing gas connected to the gas inlet for supplying at least one of Se and S to the gap.

12. The reactor according to claim 1 wherein the gap height within the at least one chamber that contains the gas inlet is higher than an adjacent chamber that does not contain any gas inlet.

13. The reactor according to claim 1 wherein each of the series of chambers further includes a gap entrance, a gap exit, a gap entrance seal, a gap exit seal, and a second mechanism to move the upper body and the lower body relative to each other between an open position and a closed position, such that when in the open position the substrate is moved by the first mechanism, and when in the closed position the gap is sealed by the gap entrance seal and the gap exit seal.

14. The reactor according to claim 13, wherein at least one gas outlet is associated with one of the chambers and is configured to remove a gas from the gap of the one chamber when the chamber is in the closed position.

15. The reactor according to claim 13, wherein adjacent chambers are separated by a buffer region.

16. The reactor according to claim 13, wherein the temperature controller controls a heating element and a cooling element.

17. The reactor according to claim 13 wherein the mechanism includes a supply spool and a receiving spool that are used to supply and receive, respectively, a flexible foil substrate.

18. The reactor according to claim 13, further comprising an enclosure that contains the series of chambers and the mechanism.

19. The reactor according to claim 18 wherein the mechanism includes a supply spool and a receiving spool that are used to supply and receive, respectively, a flexible foil substrate.

20. The reactor according to claim 13 further including at least one of Se-containing gas and S-containing gas connected to the gas inlet for supplying at least one of Se and S to the gap.

21. A method of forming a Group IBIIIAVIA compound layer on a surface of a flexible roll, comprising;
depositing a precursor layer comprising at least one Group IB material and at least one Group IIIA material on the surface of the flexible role,
providing at least one Group VIA material to an exposed top surface of the precursor layer; and
annealing, after or during the step of providing, the flexible roll using a series of process chambers, the step of annealing including feeding the flexible roll having the deposited precursor layer thereon from an inlet, through the series of process chambers to an outlet, each process chamber having a gap therein including a width, a height and a length, and wherein a ratio of a narrowest width to a narrowest height for each chamber is at least 15, the gap of each process chamber being set to a predetermined temperature, thereby applying the predetermined temperature to a section of the flexible roll within the gap associated therewith.

22. The method according to claim 21 further including the step of applying an inert gas to each of the gaps to clear atmosphere therein before feeding the flexible roll through the gaps.

23. The method according to claim 21 wherein the step of providing comprises delivering a process gas containing the at least one Group VIA material into the gap.

24. The method according to claim 21 wherein the step of providing comprises depositing a layer of the at least one Group VIA material on the exposed top surface of the precursor layer before the step of annealing.

25. The method according to claim 24 wherein the step of providing further comprises delivering a process gas containing at least one Group VIA material into the gap during the step of annealing.

26. The method according to claim 25 wherein the step of providing comprises depositing a layer of Se on the exposed surface of the precursor layer before the step of annealing and delivering a process gas containing S into the gap during the step of annealing.

27. The method according to claim 26 wherein each process chamber includes an upper body, a lower body, a gap entrance seal and a gap exit seal, and
wherein the step of annealing further includes the step of moving the upper body and the lower body of each process chamber relative to each other between an open position and a closed position, such that when in the open position the flexible roll is moved and when in the closed position the gap is sealed by the gap entrance seal and the gap exit seal and the flexible roll is stationery.

28. The method according to claim 24 wherein the step of annealing includes the step of flowing an inert gas through the gap of at least one of the process chambers during the step of annealing.

29. The method according to claim 28 wherein the step of annealing includes the step of flowing an inert gas through the gap of each of the process chambers during the step of annealing.

30. The method according to claim 24 wherein depositing the layer of at least one Group VIA material is carried out on a section of the exposed top surface of the precursor layer as the flexible roll moves and prior to that section of the flexible roll being fed into the inlet.

31. The method according to claim 30 wherein the step of annealing includes the step of flowing an inert gas through the gap of at least one of the process chambers during the step of annealing.

32. The method according to claim31 wherein the step of annealing includes the step of flowing an inert gas through the gap of each of the process chambers during the step of annealing.

33. The method according to claim 30 wherein the step of providing further comprises delivering a process gas containing at least one Group VIA material into the gap during the step of annealing.

34. The method according to claim 21 wherein each process chamber includes an upper body, a lower body, a gap entrance seal and a gap exit seal, and
wherein the step of annealing further includes the step of moving the upper body and the lower body of each process chamber relative to each other between an open position and a closed position, such that when in the open position the flexible roll is moved and when in the closed position the gap is sealed by the gap entrance seal and the gap exit seal and the flexible roll is stationery.

35. The method according to claim 34 wherein during the step of annealing an exposed top surface of the precursor is in close proximity to the upper body of at least one of the process chambers when that at least one process chamber is in the closed position.

36. The method according to claim 35 wherein the exposed top surface of the precursor is in close proximity to a porous section of the upper body of the at least one process chamber.

37. The method according to claim 36 further including the step of flowing one of a gas and vapor through the porous section to the exposed top surface of the precursor.

38. The method according to claim 36 wherein the close proximity is within about 1 mm.

39. The method according to claim 35 wherein the exposed top surface of the precursor is in contact with a porous section of the upper body of the at least one process chamber.

40. The method according to claim 39 further including the step of flowing one of a gas and vapor through the porous section to the exposed top surface of the precursor.

## Patentansprüche

1. Ein Inlinereaktor zum Prozessieren eines Substrats entsprechend eines vorgegebenen Temperaturprofils, der Reaktor umfasst;
ein Substrateinlass;
ein Substratauslass;
eine Reihe von Kammern zwischen dem Einlass und dem Auslass, jede Kammer umfassend:
einen oberen Aufbau,
einen unteren Aufbau,
einen Spalt gebildet zwischen dem oberen Aufbau und dem unteren Aufbau, wobei der Spalt eine Breite, eine Höhe und eine Länge umfasst, und wobei ein Verhältnis von einer schmalsten Breite zu einer schmalsten Höhe für jede Kammer mindestens 15 ist, und wobei der Spalt von jeder von der Reihe von Kammern ausgerichtet ist an dem Spalt der anderen Kammern in der Reihe, und
einem Temperaturregler der die Temperatur regelt innerhalb des Spalts ausgehend von dem vorgegebenen Temperaturprofil sodass eine unterschiedliche Temperatur innerhalb des Spaltes von mindestens einigen der Kammern herrscht;
einem Mechanismus zum Bewegen des Substrats von dem Einlass zu dem Auslass durch jeden Spalt der Reihe von Kammern; und mindestens einen Gaseinlass konfiguriert zum Einbringen eines Gases in den Spalt mindestens einer der entsprechenden Kammern.

2. Der Reaktor gemäß Anspruch 1, wobei angrenzende Kammern durch einen Pufferbereich getrennt sind.

3. Der Reaktor gemäß Anspruch 2, wobei die Höhe des Spaltes innerhalb mindestens einer Kammer über deren Breite variiert.

4. Der Reaktor gemäß Anspruch 3, wobei die Höhe des Spaltes innerhalb mindestens einer Kammer über deren Länge variiert.

5. Der Reaktor gemäß Anspruch 2, wobei die Höhe des Spaltes innerhalb mindestens einer Kammer über deren Länge variiert.

6. Der Reaktor gemäß Anspruch 1, wobei die Höhe des Spaltes innerhalb mindestens einiger Kammern unterschiedlich ist.

7. Der Reaktor gemäß Anspruch 1, wobei die Höhe des Spaltes innerhalb jeder Kammer im Wesentlichen die gleiche ist.

8. Der Reaktor gemäß Anspruch 1, wobei der Temperaturregler ein Heizelement und ein Kühlelement regelt.

9. Der Reaktor gemäß Anspruch 1 wobei der Mechanismus eine Versorgungsrolle und eine Aufnahmerolle umfasst die verwendet werden zum Versorgen und Aufnehmen, jeweils, eines flexiblen Foliensubstrats.

10. Der Reaktor gemäß Anspruch 2, weiter umfassend ein Gehäuse das die Reihe von Kammern und den Mechanismus einschließt.

11. Der Reaktor gemäß Anspruch 1 weiter umfassend mindestens ein Seenthaltendes Gas und S-enthaltendes Gas angeschlossen an den Gaseinlass zur Versorgung mit mindestens einem der Se und S des Spaltes.

12. Der Reaktor gemäß Anspruch 1 wobei die Höhe des Spaltes innerhalb der mindestens einen Kammer die den Gaseinlass enthält höher ist als eine angrenzende Kammer die keinen Gaseinlass enthält.

13. Der Reaktor gemäß Anspruch 1 wobei jede der Reihe von Kammern weiter umfasst einen Eingangsspalt, einen Ausgangsspalt, eine Abdichtung des Eingangsspaltes, eine Abdichtung des Ausgangsspaltes, und einen zweiten Mechanismus zum Bewegen des oberen Aufbaus und des unteren Aufbaus relativ zu einander zwischen einer offenen Stellung und einer geschlossenen Stellung, sodass in der offenen Stellung das Substrat durch den ersten Mechanismus bewegt wird, und in der geschlossenen Stellung der Spalt abgedichtet wird durch die Abdichtung des Eingangsspaltes und die Abdichtung des Ausgangsspaltes.

14. Der Reaktor gemäß Anspruch 13, wobei mindestens ein Gasauslass mit einer der Kammern verbunden ist und konfiguriert ist zum Entfernen von Gas von dem Spalt der einen Kammer wenn die Kammer in der geschlossenen Stellung ist.

15. Der Reaktor gemäß Anspruch 13, wobei angrenzende Kammern durch einen Pufferbereich getrennt sind.

16. Der Reaktor gemäß Anspruch 13, wobei der Temperaturregler ein Heizelement und ein Kühlelement regelt.

17. Der Reaktor gemäß Anspruch 13 wobei der Mechanismus eine Versorgungsrolle und eine Aufnahmerolle umfasst die verwendet werden zum Versorgen und Aufnehmen, jeweils, eines flexiblen Foliensubstrats.

18. Der Reaktor gemäß Anspruch 13, weiter umfassend ein Gehäuse das die Reihe von Kammern und den Mechanismus einschließt.

19. Der Reaktor gemäß Anspruch 18 wobei der Mechanismus eine Versorgungsrolle und eine Aufnahmerolle umfasst die verwendet werden zum Versorgen und Aufnehmen, jeweils, eines flexiblen Foliensubstrats.

20. Der Reaktor gemäß Anspruch 13 weiter umfassend mindestens ein Seenthaltendes Gas und S-enthaltendes Gas angeschlossen an den Gaseinlass zur Versorgung mit mindestens einem der Se und S des Spaltes.

21. Ein Verfahren zur Ausbildung einer Gruppe IBIIIAVIA Verbundschicht auf einer Oberfläche einer flexiblen Rolle, umfassend;
Abscheiden einer Präkursorschicht umfassend mindestens ein Gruppe IB Material und mindestens ein Gruppe IIIA Material auf der Oberfläche der flexiblen Rolle,
Bereitstellen mindestens eines Gruppe VIA Materials auf eine freiliegende Oberseite der Präkursorschicht; und
Tempern, nach oder während des Schrittes der Bereitstellung, der flexiblen Rolle unter Verwendung einer Reihe von Prozesskammern, der Schritt des Temperns umfasst ein Zuführen der flexiblen Rolle mit der darauf abgeschiedenen Präkursorschicht von einem Einlass, durch die Reihe von Prozesskammern zu einem Auslass, jede Prozesskammer weist einen Spalt darin auf umfassend eine Breite, eine Höhe und eine Länge, und wobei ein Verhältnis von einer schmalsten Breite zu einer schmalsten Höhe für jede Kammer mindestens 15 ist, der Spalt von jeder Prozesskammer auf eine vorgegebene Temperatur gesetzt wird, dabei die vorgegebene Temperatur auf einen Teil der flexiblen Rolle innerhalb des zugehörigen Spalts angewendet wird.

22. Das Verfahren gemäß Anspruch 21 weiter umfassend den Schritt der Anwendung eines inerten Gases auf jeden der Spalte um die Atmosphäre darin abzuziehen bevor die flexible Rolle durch die Spalten zugeführt wird.

23. Das Verfahren gemäß Anspruch 21 wobei der Schritt der Bereitstellung die Lieferung eines Prozessgases enthaltend mindestens ein Gruppe VIA Material in den Spalt umfasst.

24. Das Verfahren gemäß Anspruch 21 wobei der Schritt der Bereitstellung die Abscheidung einer Schicht aus dem mindestens einem Gruppe VIA Material auf der freiliegenden Oberseite der Präkursorschicht vor dem Schritt des Temperns umfasst.

25. Das Verfahren gemäß Anspruch 24 wobei der Schritt der Bereitstellung weiter die Lieferung eines Prozessgases enthaltend mindestens ein Gruppe VIA Material in den Spalt während des Schrittes des Temperns umfasst.

26. Das Verfahren gemäß Anspruch 25 wobei der Schritt der Bereitstellung die Abscheidung einer Schicht aus Se auf der freiliegenden Oberfläche der Präkursorschicht vor dem Schritt des Temperns und die Lieferung eines Prozessgases enthaltend S in den Spalt während des Schrittes des Temperns umfasst.

27. Das Verfahren gemäß Anspruch 26 wobei jede Prozesskammer einen oberen Aufbau, einen unteren Aufbau, eine Abdichtung des Eingangsspaltes und eine Abdichtung des Ausgangsspaltes umfasst, und
wobei der Schritt des Temperns weiter umfasst den Schritt eines Bewegens des oberen Aufbaus und des unteren Aufbaus von jeder Prozesskammer relativ zu einander zwischen einer offenen und einer geschlossenen Stellung, sodass in der offenen Stellung die flexible Rolle bewegt wird und in der geschlossenen Stellung der Spalt durch die Abdichtung des Eingangsspaltes und die Abdichtung des Ausgangsspaltes abgedichtet wird und die flexible Rolle ruhend ist.

28. Das Verfahren gemäß Anspruch 24 wobei der Schritt des Temperns den Schritt eines Strömens eines inerten Gases durch den Spalt von mindestens einer der Prozesskammern während dem Schritt des Temperns umfasst.

29. Das Verfahren gemäß Anspruch 28 wobei der Schritt des Temperns den Schritt des Strömens eines inerten Gases durch den Spalt von jeder der Prozesskammern während dem Schritt des Temperns umfasst.

30. Das Verfahren gemäß Anspruch 24 wobei die Abscheidung der Schicht von mindestens einem Gruppe VIA Material ausgeführt wird in einem Teil der freiliegenden Oberseite der Präkursorschicht wenn sich die flexible Rolle bewegt und vor dem Teil der flexiblen Rolle welcher in den Einlass zugeführt wird.

31. Das Verfahren gemäß Anspruch 30 wobei der Schritt des Temperns den Schritt des Strömens eines inerten Gases durch den Spalt von mindestens einer der Prozesskammern während des Schrittes des Temperns umfasst.

32. Das Verfahren gemäß Anspruch 31 wobei der Schritt des Temperns den Schritt des Strömens eines inerten Gases durch den Spalt von jeder der Prozesskammern während des Schrittes des Temperns umfasst.

33. Das Verfahren gemäß Anspruch 30 wobei der Schritt des Bereitstellens weiter die Lieferung eines Prozessgases enthaltend mindestens ein Gruppe VIA Material in den Spalt während des Schrittes des Temperns umfasst.

34. Das Verfahren gemäß Anspruch 21 wobei jede Prozesskammer einen oberen Aufbau, einen unteren Aufbau, eine Abdichtung des Eingangsspaltes und eine Abdichtung des Ausgangsspaltes umfasst, und
wobei der Schritt des Temperns weiter umfasst den Schritt eines Bewegens des oberen Aufbaus und des unteren Aufbaus von jeder Prozesskammer relativ zu einander zwischen einer offenen und einer geschlossenen Stellung, sodass in der offenen Stellung die flexible Rolle bewegt wird und in der geschlossenen Stellung der Spalt durch die Abdichtung des Eingangsspaltes und die Abdichtung des Ausgangsspaltes abgedichtet wird und die flexible Rolle ruhend ist.

35. Das Verfahren gemäß Anspruch 34 wobei während des Schrittes des Temperns eine freiliegende Oberseite des Präkursors in geringem Abstand zu dem oberen Aufbau von mindestens einer der Prozesskammern ist wenn sich diese mindestens eine Prozesskammer in der geschlossenen Stellung befindet.

36. Das Verfahren gemäß Anspruch 35 wobei die freiliegende Oberseite des Präkursors in geringem Abstand zu einem porösen Teil des oberen Aufbaus der mindestens einen Prozesskammer ist.

37. Das Verfahren gemäß Anspruch 36 weiter umfassend den Schritt des Strömens eines Gases und Dampfes durch den porösen Teil zu der freiliegenden Oberseite des Präkursors.

38. Das Verfahren gemäß Anspruch 36 wobei der geringe Abstand innerhalb ungefähr 1 mm ist.

39. Das Verfahren gemäß Anspruch 35 wobei die freiliegende Oberseite des Präkursors in Kontakt mit einem porösen Teil des oberen Aufbaus der mindestens einen Prozesskammer ist.

40. Das Verfahren gemäß Anspruch 39 weiter umfassend den Schritt des Strömens eines Gases oder Dampfes durch den porösen Teil zu der freiliegenden Oberseite des Präkursors.

## Revendications

1. Réacteur en ligne pour traiter un substrat selon un profil de température prédéterminé, le réacteur comprenant :
une admission de substrat ;
un refoulement de substrat ;
une série de chambres entre l'admission et le refoulement, chaque chambre incluant :
un corps supérieur,
un corps inférieur,
un espace formé entre le corps supérieur et le corps inférieur, dans lequel l'espace inclut une largeur, une hauteur et une longueur, et dans lequel un rapport entre une largeur la plus étroite et une hauteur la plus étroite pour chaque chambre est d'au moins 15, et dans lequel l'espace de chacune de la série de chambres est aligné avec l'espace des autres chambres dans la série, et
un régulateur de température qui régule la température au sein de l'espace en se basant sur le profil de température prédéterminé de sorte qu'il y ait une température différente au sein de l'espace d'au moins certaines des chambres ;
un mécanisme pour déplacer le substrat de l'admission au refoulement à travers chaque espace de la série de chambres ; et
au moins une admission de gaz configurée pour délivrer un gaz dans l'espace d'une chambre correspondante d'au moins l'une des chambres.

2. Réacteur selon la revendication 1, dans lequel des chambres adjacentes sont séparées par une région tampon.

3. Réacteur selon la revendication 2, dans lequel la hauteur d'espace au sein d'au moins une chambre varie à travers sa largeur.

4. Réacteur selon la revendication 3, dans lequel la hauteur d'espace au sein d'au moins une chambre varie à travers sa longueur.

5. Réacteur selon la revendication 2, dans lequel la hauteur d'espace au sein d'au moins une chambre varie à travers sa longueur.

6. Réacteur selon la revendication 1, dans lequel la hauteur d'espace au sein d'au moins certaines des chambres est différente.

7. Réacteur selon la revendication 1, dans lequel la hauteur d'espace au sein de chaque chambre est sensiblement la même.

8. Réacteur selon la revendication 1, dans lequel le régulateur de température régule un élément chauffant et un élément refroidissant.

9. Réacteur selon la revendication 1, dans lequel le mécanisme inclut une bobine débitrice et une bobine réceptrice qui sont utilisées pour alimenter et recevoir, respectivement, un substrat en feuille flexible.

10. Réacteur selon la revendication 2, comprenant en outre une enceinte qui contient la série de chambres et le mécanisme.

11. Réacteur selon la revendication 1, incluant en outre au moins l'un parmi un gaz contenant du Se et un gaz contenant du S raccordé à l'admission de gaz pour alimenter l'espace en au moins l'un parmi Se et S.

12. Réacteur selon la revendication 1, dans lequel la hauteur d'espace au sein de la au moins une chambre qui contient l'admission de gaz est plus haute qu'une chambre adjacente qui ne contient aucune admission de gaz.

13. Réacteur selon la revendication 1, dans lequel chacune de la série de chambres inclut en outre une entrée d'espace, une sortie d'espace, un joint d'entrée d'espace, un joint de sortie d'espace et un second mécanisme pour déplacer le corps supérieur et le corps inférieur l'un par rapport à l'autre entre une position ouverte et une position fermée, de telle sorte que, dans la position ouverte, le substrat est déplacé par le premier mécanisme, et dans la position fermée, l'espace est scellé par le joint d'entrée d'espace et le joint de sortie d'espace.

14. Réacteur selon la revendication 13, dans lequel au moins un refoulement de gaz est associé à l'une des chambres et est configuré pour éliminer un gaz de l'espace de cette chambre lorsque la chambre est dans la position fermée.

15. Réacteur selon la revendication 13, dans lequel des chambres adjacentes sont séparées par une région tampon.

16. Réacteur selon la revendication 13, dans lequel le régulateur de température régule un élément chauffant et un élément refroidissant.

17. Réacteur selon la revendication 13, dans lequel le mécanisme inclut une bobine débitrice et une bobine réceptrice qui sont utilisées pour alimenter et recevoir, respectivement, un substrat en feuille flexible.

18. Réacteur selon la revendication 13, comprenant en outre une enceinte qui contient la série de chambres et le mécanisme.

19. Réacteur selon la revendication 18, dans lequel le mécanisme comprend une bobine débitrice et une bobine réceptrice qui sont utilisées pour alimenter et recevoir, respectivement, un substrat en feuille flexible.

20. Réacteur selon la revendication 13, incluant en outre au moins l'un parmi un gaz contenant du Se et un gaz contenant du S raccordé à l'admission de gaz pour alimenter l'espace en au moins l'un parmi Se et S.

21. Procédé de formation d'une couche de composé du groupe IBIIIAVIA sur une surface d'un rouleau flexible, comprenant les étapes pour :
déposer une couche de précurseur comprenant au moins un matériau du groupe IB et au moins un matériau du groupe IIIA sur la surface du rouleau flexible,
fournir au moins un matériau du groupe VIA à une surface de dessus exposée de la couche de précurseur ; et
recuire, après ou pendant l'étape de fourniture, le rouleau flexible en utilisant une série de chambres de traitement, l'étape de recuit incluant l'alimentation du rouleau flexible sur lequel se trouve la couche de précurseur déposée à partir d'une admission, à travers la série de chambres de traitement vers un refoulement, chaque chambre de traitement renfermant un espace incluant une largeur, une hauteur et une longueur, et dans lequel un rapport entre une largeur la plus étroite et une hauteur la plus étroite pour chaque chambre est d'au moins 15, l'espace de chaque chambre de traitement étant réglé à une température prédéterminée, appliquant de ce fait la température prédéterminée à une section du rouleau flexible au sein de l'espace qui lui est associé.

22. Procédé selon la revendication 21, incluant en outre une étape pour appliquer un gaz inerte à chacun des espaces pour y dégager l'atmosphère avant d'alimenter le rouleau flexible à travers les espaces.

23. Procédé selon la revendication 21, dans lequel l'étape de fourniture comprend la délivrance d'un gaz de traitement contenant le au moins un matériau de groupe VIA dans l'espace.

24. Procédé selon la revendication 21, dans lequel l'étape de fourniture comprend le dépôt d'une couche du au moins un matériau du groupe VIA sur la surface de dessus exposée de la couche de précurseur avant l'étape de recuit.

25. Procédé selon la revendication 24, dans lequel l'étape de fourniture comprend la délivrance d'un gaz de traitement contenant au moins un matériau du groupe VIA dans l'espace pendant l'étape de recuit.

26. Procédé selon la revendication 25, dans lequel l'étape de fourniture comprend le dépôt d'une couche de Se sur la surface exposée de la couche de précurseur pendant l'étape de recuit et la délivrance d'un gaz de traitement contenant du S dans l'espace pendant l'étape de recuit.

27. Procédé selon la revendication 26, dans lequel chaque chambre de traitement inclut un corps supérieur, un corps inférieur, un joint d'entrée de gaz et un joint de sortie de gaz, et
dans lequel l'étape de recuit inclut en outre une étape pour déplacer le corps supérieur et le corps inférieur de chaque chambre de traitement l'un par rapport à l'autre entre une position ouverte et une position fermée, de telle sorte que dans la position ouverte, le rouleau flexible est déplacé et dans la position fermée, l'espace est scellé par le joint d'entrée d'espace et le joint de sortie d'espace, et le rouleau flexible est stationnaire.

28. Procédé selon la revendication 24, dans lequel l'étape de recuit inclut une étape pour écouler un gaz inerte à travers l'espace d'au moins l'une des chambres de traitement pendant l'étape de recuit.

29. Procédé selon la revendication 28, dans lequel l'étape de recuit inclut une étape pour écouler un gaz inerte à travers l'espace de chacune des chambres de traitement pendant l'étape de recuit.

30. Procédé selon la revendication 24, dans lequel le dépôt de la couche d'au moins un matériau du groupe VIA est réalisé sur une section de la surface de dessus exposée de la couche de précurseur à mesure que le rouleau flexible se déplace et avant que cette section du rouleau flexible soit alimentée dans l'admission.

31. Procédé selon la revendication 30, dans lequel l'étape de recuit inclut une étape pour écouler un gaz inerte à travers l'espace d'au moins l'une des chambres de traitement pendant l'étape de recuit.

32. Procédé selon la revendication 31, dans lequel l'étape de recuit inclut une étape pour écouler un gaz inerte à travers l'espace de chacune des chambres de traitement pendant l'étape de recuit.

33. Procédé selon la revendication 30, dans lequel l'étape de fourniture comprend en outre la délivrance d'un gaz de traitement contenant au moins un matériau du groupe VIA dans l'espace pendant l'étape de recuit.

34. Procédé selon la revendication 21, dans lequel chaque chambre de traitement inclut un corps supérieur, un corps inférieur, un joint d'entrée de gaz et un joint de sortie de gaz, et
dans lequel l'étape de recuit inclut en outre une étape pour déplacer le corps supérieur et le corps inférieur de chaque chambre de traitement l'un par rapport à l'autre entre une position ouverte et une position fermée, de telle sorte que dans la position ouverte, le rouleau flexible est déplacé et dans la position fermée, l'espace est scellé par le joint d'entrée d'espace et le joint de sortie d'espace, et le rouleau flexible est stationnaire.

35. Procédé selon la revendication 34, dans lequel, pendant l'étape de recuit, une surface de dessus exposée du précurseur est à proximité étroite du corps supérieur d'au moins l'une des chambres de traitement lorsque la au moins une chambre de traitement est dans la position fermée.

36. Procédé selon la revendication 35, dans lequel la surface de dessus exposée du précurseur est à proximité étroite d'une section poreuse du corps supérieur de la au moins une chambre de traitement.

37. Procédé selon la revendication 36, incluant en outre une étape pour écouler l'un d'un gaz et d'une vapeur à travers la section poreuse vers la surface de dessus exposée du précurseur.

38. Procédé selon la revendication 36, dans lequel la proximité étroite est de moins d'environ 1 mm.

39. Procédé selon la revendication 35, dans lequel la surface de dessus exposée du précurseur est en contact avec une section poreuse du corps supérieur de la au moins une chambre de traitement.

40. Procédé selon la revendication 39, incluant en outre l'étape consistant à écouler l'un parmi un gaz et une vapeur à travers la section poreuse vers la surface de dessus exposée du précurseur.
